# EUROPEAN PATENT APPLICATION

(11) **EP 2 775 807 A1**
(43) Date of publication of application: **10.09.2014**
(21) Application number: 12846388.2
(22) Date of filing: 30.10.2012
(51) Int. Cl.: H05K 3/12, H05K 3/10

(54) **BASE MATERIAL FOR FORMING ELECTROCONDUCTIVE PATTERN, CIRCUIT BOARD, AND METHOD FOR PRODUCING EACH**

(30) Priority: 02.11.2011 JP 2011240730; 29.10.2012 JP 2012237384
(71) Applicant: Fujifilm Corporation, Minato-ku Tokyo 106-8620 (JP)
(72) Inventor: TATSUTA Takeichi, Ashigarakami-gun, Kanagawa 258-8577 (JP)
(74) Representative: HOFFMANN EITLE
(86) International application number: PCT/JP2012/078036
(87) International publication number: WO 2013/065683

(57) **Abstract**

The present invention pertains to: a base material (10) for forming an electroconductive pattern, adapted to form an electroconductive pattern and obtain a circuit board; the circuit board obtained therefrom; and a method for producing each. The base material (10) for forming an electroconductive pattern, adapted to obtain a circuit board, includes a supporter (12), and a holding region (14) for holding a fluid body (40) for obtaining an electroconductive pattern, the holding region being formed atop one end surface of the supporter (12) and exhibiting a proper wettability for the fluid body (40). The holding region (14) has at least a first linear group (18) comprising a plurality of first lines (16) extending in parallel with each other along a first direction, and a second linear group (22) comprising a plurality of second lines (20) extending in parallel with each other along a second direction, and a grid shape is formed by the first linear group (18) and second linear group (22) .

## Description

### Technical Field

The present invention relates to a conductive pattern-forming substrate, on which a conductive pattern is formed to produce a circuit board (a base material for forming an electroconductive pattern), and further relates to a circuit board produced from the conductive pattern-forming substrate, as well as to a method for producing the same.

### Background Art

Circuit boards such as rigid printed circuit boards and flexible printed circuit boards are used for establishing conduction between electronic components. Such a circuit board is produced by forming a conductive pattern on a conductive pattern-forming substrate. In general, the conductive pattern-forming substrate is produced by a subtractive method or an additive method. In the subtractive method, a metal foil made of copper or the like is disposed on one surface of a support, and a desired pattern is formed from the metal foil by a mask etching process. In the additive method, a mask is disposed on a support, and a pattern plating treatment is carried out.

However, particularly in the case that various types of conductive patterns are formed, in which only a small number of each type of conductive pattern is formed (i.e., during production of a wide variety of conductive patterns in small quantities), such conventional methods are poor in efficiency. This is because, according to conventional methods, the shape of the mask has to be changed depending on the shape of the conductive pattern. Furthermore, according to conventional methods, it is necessary to perform a mask forming process and an exposure process. In addition, a waste liquid treatment is required. Thus, such conventional methods are particularly disadvantageous in that complicated procedures are carried out with high cost.

As proposed in Japanese Laid-Open Patent Publication No. 64-005095, a conductive pattern can be formed by printing (e.g., inkjet printing) an ink containing a metal powder. However, in this case, droplets of ink may land in a wrong position, and connection or deformation of the droplets (hereinafter referred to as landing interference) may be caused on the surface of the support. In a case where such a phenomenon is caused, the conductive pattern may become broken and have a non-uniform size in the width direction.

In Japanese Patent No. 4575725, an electrode and a polyimide material layer are formed in this order on a base, a surface of the polyimide material layer is irradiated with ultraviolet rays using a mask in order to form a pattern containing a high-surface-energy portion and a low-surface-energy portion, and thereafter, an inkjet process is carried out. In this case, as described in Japanese Patent No. 4575725, a conductive layer can be formed only on the high-surface-energy portion.

In Japanese Laid-Open Patent Publication No. 11-207959, affinity regions that exhibit high wettability and non-affinity regions that exhibit low wettability with respect to an ink are formed in a checkered (checkered flag) pattern, and the ink is applied only to the affinity regions.

### Summary of Invention

With the technique described in Japanese Patent No. 4575725, during exposure, for achieving a difference in surface energy, the surface must be exposed in a pattern that corresponds to the shape of the conductive pattern. Therefore, such a technique is not suitable for production of a wide variety of conductive patterns in small quantities.

With the technique described in Japanese Laid-Open Patent Publication No. 11-207959, in a case in which a droplet of ink lands on a wrong region that differs from the affinity region, an image defect is caused in the wrong region. Further, inkjet printing processes are disadvantageous in that a relatively large landing position gap may be formed. In particular, high-speed printing processes tend to cause a significantly large position gap. In addition, the range in which landing interference occurs cannot be easily controlled. Thus, with the technique described in Japanese Laid-Open Patent Publication No. 11-207959, it is difficult to efficiently draw a straight line having a predetermined size in the width direction.

A general object of the present invention is to provide a conductive pattern-forming substrate, which is useful for production of a wide variety of products in small quantities.

A principal object of the invention is to provide a conductive pattern-forming substrate, which is suitable for efficiently drawing a straight line having a predetermined size in the width direction of a conductive pattern.

Another object of the invention is to provide a method for producing the above conductive pattern-forming substrate.

A further object of the invention is to provide a circuit board produced from the conductive pattern-forming substrate.

A still further object of the invention is to provide a method for producing the circuit board.

The above objects are accomplished by the following configurations [1] to [4] described below.
[1] A conductive pattern-forming substrate, on which a conductive pattern is formed to produce a circuit board, comprising:
   a support; and
   a holding region formed on at least one surface of the support for holding a fluid that forms the conductive pattern;
   wherein:
      the holding region has a wettability with respect to the fluid that is higher than that of a surrounding region around the holding region;
      the holding region contains at least a first straight line group and a second straight line group, the first straight line group contains a plurality of first straight lines extending parallel to each other in a first direction, and the second straight line group contains a plurality of second straight lines extending parallel to each other in a second direction; and
      the first straight line group and the second straight line group are combined to form lattice shapes.
[2] A method for producing a conductive pattern-forming substrate, on which a conductive pattern is formed to produce a circuit board, comprising a step of forming a holding region on a support,
   wherein:
   the holding region has a wettability with respect to a fluid used for forming the conductive pattern that is higher than that of a surrounding region, and the holding region is used for holding the fluid;
   at least a first straight line group and a second straight line group are formed to thereby obtain the holding region, the first straight line group contains a plurality of first straight lines extending parallel to each other in a first direction, and the second straight line group contains a plurality of second straight lines extending parallel to each other in a second direction; and
   the first straight line group and the second straight line group are combined to form lattice shapes.
[3] A circuit board comprising the conductive pattern-forming substrate, and a conductive pattern, wherein the conductive pattern is formed on a portion in the holding region that contains a plurality of the straight line groups.
[4] A method for producing a circuit board comprising the step of forming a conductive pattern on the conductive pattern-forming substrate, wherein the conductive pattern is formed on a portion in the holding region that contains a plurality of the straight line groups.

The support preferably has an insulating property. In this case, a conductive metal layer may be interposed between the support and the holding region, wherein the conductive pattern is formed from the conductive metal layer.

The above objects, features, and advantages of the present invention will become more apparent from the following description when taken in conjunction with the accompanying drawings.

### Brief Description of Drawings

FIG. 1 is a fragmentary vertical sectional view of a conductive pattern-forming substrate according to a first embodiment;
FIG. 2 is a fragmentary plan view of the conductive pattern-forming substrate of FIG. 1;
FIG. 3 is a plan view of a conductive pattern-forming substrate having affinity regions and non-affinity regions arranged in a checkered (checkered flag) pattern;
FIG. 4 is a plan view of a conductive pattern-forming substrate having affinity regions and non-affinity regions arranged in a horizontal stripe pattern;
FIG. 5 is a plan view of a conductive pattern, which is bent and redirected at a right angle;
FIG. 6 is a plan view of a conductive pattern, which is bent and redirected at an obtuse angle;
FIG. 7 is a plan view of a holding region having a simple square lattice shape;
FIG. 8 is a plan view of a holding region having a simple square lattice shape and a diagonal line;
FIG. 9 is a plan view of a holding region having diagonal lines, in which orientations of the diagonal lines in adjacent lattice shapes are different in an A direction and are the same in a B direction;
FIG. 10 is a plan view of a holding region having diagonal lines, in which orientations of the diagonal lines in adjacent lattice shapes are different in both the A direction and the B direction;
FIG. 11 is a plan view of a holding region having broken lines formed by first and second straight lines shown in FIG. 7;
FIG. 12 is a plan view of a fluid, which is printed on both of two straight lines that cross each other;
FIG. 13 is a plan view of a fluid, which is printed on both of a first broken line and a second broken line that extend in a perpendicular direction;
FIG. 14 is a plan view of a holding region having broken lines formed by first through fourth straight lines shown in FIG. 2;
FIG. 15 is a plan view of a holding region having broken lines formed by first, second, and fourth straight lines shown in FIG. 8;
FIG. 16 is a plan view of a holding region having broken lines formed by first through fourth straight lines shown in FIG. 9;
FIG. 17 is a plan view of a holding region having broken lines formed by first to fourth straight lines shown in FIG. 10;
FIG. 18 is a plan view of a holding region having broken lines formed by the first to fourth straight lines shown in FIG. 2, which have shapes different from those of FIG. 14;
FIG. 19 is a plan view of a holding region having assemblies of first and second straight lines;
FIG. 20 is a plan view of the fluid spread in the width direction of adjacent first (second) straight lines arranged at a large distance;
FIG. 21 is a plan view of the fluid spread in the width direction of adjacent first (second) straight lines arranged at a small distance;
FIG. 22 is a fragmentary vertical sectional view of a conductive pattern-forming substrate according to a second embodiment;
FIG. 23 is a partially enlarged plan view of a conductive pattern, which is formed on the conductive pattern-forming substrate shown in FIG. 6, by causing fluids having different viscosities to land on intersections and the other portions, respectively;
FIG. 24 is a partially enlarged plan view of a conductive pattern, which is formed on the conductive pattern-forming substrate shown in FIG. 6, by causing fluids having the same viscosity to land on the intersections and the other portions; and
FIG. 25 is a partially enlarged plan view of a conductive pattern, which is formed on the conductive pattern-forming substrate shown in FIG. 6, by causing a fluid to land such that dots are formed having different diameters on the intersections and the other portions.

### Description of Embodiments

Several preferred embodiments of the circuit board and the production method of the present invention will be described in detail below with reference to the accompanying drawings, in relation to a conductive pattern-forming substrate used for forming the circuit board, and a method for producing the substrate.

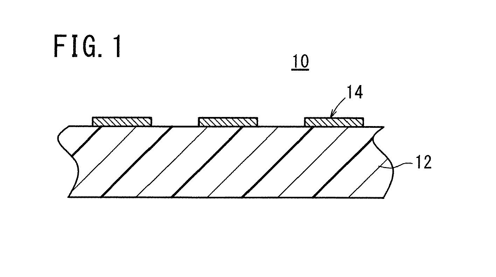

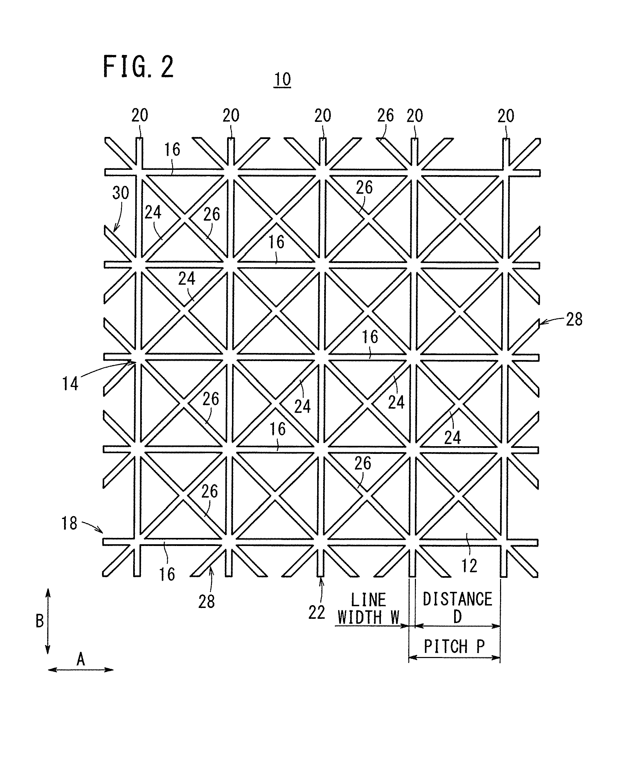

FIG. 1 is a fragmentary vertical sectional view of a conductive pattern-forming substrate 10 according to a first embodiment, and FIG. 2 is a fragmentary plan view of the conductive pattern-forming substrate 10. The conductive pattern-forming substrate 10 has a support 12, and a holding region 14 formed on one surface of the support 12.

The support 12 preferably is composed of a flame-resistant insulating material such as polyimide, heat-resistant polyethylene terephthalate (PET), polyethylene naphthalate (PEN), glass epoxy, bakelite, or any of various ceramics. The support 12, which is composed of such a material, has a wettability with respect to a fluid (to be described later) that is lower than that of the holding region 14. Therefore, in a case where the fluid is brought into contact with the support 12, the fluid tends to be repelled by the support 12.

The holding region 14 has a desired wettability with respect to the fluid, so that the fluid is held on the holding region 14. The contact angle between the fluid and the holding region 14 is significantly smaller than the contact angle between the fluid and the exposed surface of the support 12, or the contact area between the fluid and a membrane (not shown) formed on the surface. Thus, the holding region 14 acts as an affinity region, whereas the exposed surface of the support 12 or the membrane acts as a non-affinity region.

In general, wettability of a solid with respect a given liquid depends on the surface energy of the solid and the surface tension of the liquid. Therefore, the holding region 14, which has a lattice shape (straight line group), is formed on the surface of the conductive pattern-forming substrate 10, and the surface energy of the holding region 14 differs significantly from the surface energy of the surrounding regions. Consequently, the fluid can become attached readily to the holding region 14.

Thus, as the surface energy of the holding region 14 differs more significantly from the surface energy of the surrounding regions, a droplet of the fluid is introduced more readily to the holding region 14. In the case that a polar ink (to be described later) is used as the fluid, it is preferred that the surface energy of the holding region 14 is higher by at least 5 mJ/m² than the surface energy of the surrounding regions. More preferably, the surface energy of the holding region 14 is higher by at least 10 mJ/m², and even more preferably, is higher by at least 20 mJ/m², than the surface energy of the surrounding regions.

Conversely, in the case of using a non-polar ink (to be described later) as the fluid, the surface energy of the holding region 14 is made lower than the surface energy of the surrounding regions. In this case, preferably, the surface energy of the holding region 14 is lower by at least 5 mJ/m² than the surface energy of the surrounding regions. More preferably, the surface energy of the holding region 14 is lower by at least 10 mJ/m², and even more preferably, is lower by at least 20 mJ/m², than the surface energy of the surrounding regions.

Thus, in the above manner, by controlling the surface energy difference between the holding region 14 and the surrounding regions depending on the characteristics of the fluid, the fluid wettability of the holding region 14 can be made higher than the fluid wettability of the surrounding regions.

The holding region 14 contains a plurality of first straight lines 16 extending parallel to each other in the horizontal direction (the direction of the arrow A /the first direction) of FIG. 2. The first straight lines 16 are arranged so as to form a first straight line group 18. The first straight lines 16 cross one another at an angle of approximately 90°, with a plurality of second straight lines 20 extending parallel to each other in the vertical direction (the direction of the arrow B/the second direction). The second straight lines 20 are arranged so as to form a second straight line group 22. The first straight line group 18 and the second straight line group 22 are combined to form a square lattice shape.

As shown in FIG. 2, the holding region 14 further contains, as diagonal lines of the square lattice shape, third straight lines 24 that extend from the first straight lines 16 toward the second straight lines 20, and fourth straight lines 26 that extend from the first straight lines 16 toward the second straight lines 20 perpendicularly with respect to the third straight lines 24. The third straight lines 24 and the fourth straight lines 26 are arranged at an angle of approximately 45° with respect to the first straight lines 16 and the second straight lines 20. Therefore, the first straight line 16, the second straight line 20, the third straight line 24, and the fourth straight line 26 cross over each other at each of the intersections in the lattice shape. Thus, eight straight lines extend radially from one of the intersections (other than intersections on the edge). Consequently, in this case, socalled octagonal lattices are connected to each other.

A plurality of third straight lines 24 and a plurality of fourth straight lines 26 are arranged so as to form a third straight line group 28 and a fourth straight line group 30, respectively.

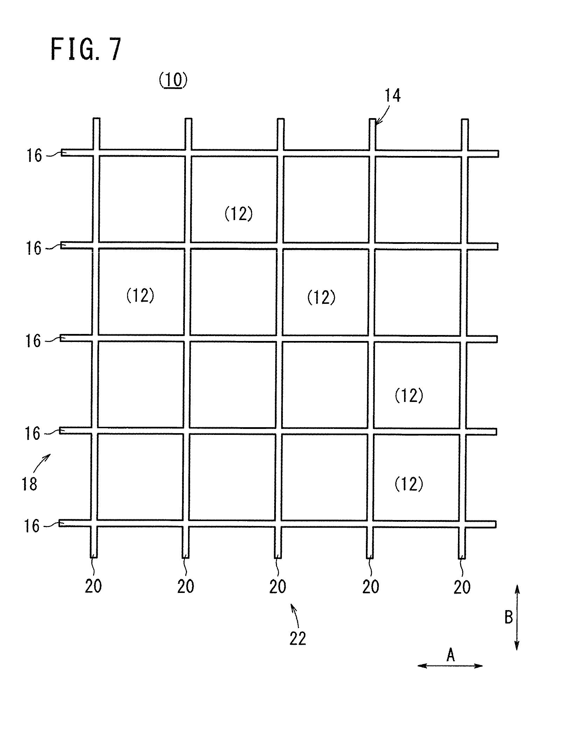

The first straight lines 16, the second straight lines 20, the third straight lines 24, and the fourth straight lines 26 each have a predetermined line width W, respectively, and the straight lines, which lie parallel to each other, are arranged at a predetermined pitch P. Plural straight lines are combined in order to form an octagonal lattice, a tetragonal lattice, etc. (see FIG. 7).

The distance D, which is obtained by subtracting the line width W from the pitch P, preferably is greater than the line width W. More specifically, the line width W preferably is defined by the distance D x 0.9 or less, and more preferably, is defined by the distance D x 0.75 or less.

However, on the condition that the line width W is reduced excessively, it is possible only for an image with a low circuit density to be formed, whereby the freedom with which wiring and components can be selected is reduced. Therefore, the line width W and the pitch P are selected appropriately depending on the intended use. Thus, preferably, the substrate has a line width W and a pitch P, which are suitable for production of the circuit board.

The line width W preferably is 3 to 130 µm, more preferably, is 4 to 100 µm, and particularly preferably, is 5 to 75 µm.

In a case where the liquid diameter of the fluid that forms the conductive pattern is significantly larger than the line width W, the fluid scarcely is retained within the straight line shape of the holding region 14, and tends to spread out to surrounding regions in the vicinity of the holding region 14 (straight line). On the other hand, in a case where the liquid diameter is significantly smaller, the fluid does not spread sufficiently, resulting in insufficient wetting, so that productivity of the circuit board is lowered. Furthermore, in certain cases, the adjacent dots of the spread droplets are not connected to each other, thereby resulting in a disconnected state in which the spread droplets fail to function as a wiring. Therefore, preferably, an appropriate combination of the line width W and the droplet diameter is selected. More specifically, in the circuit board production method, the relationship between the line width W and the equivalent spherical diameter of the fluid droplets preferably is such that the line width W is 1/5 to 6 times as large as the equivalent spherical diameter, and particularly preferably, is such that the line width W is 1/3 to 5 times as large as the equivalent spherical diameter.

The holding region 14 having the above shape may be formed by flexographic printing, gravure printing, or the like, using a holding region-forming fluid containing a hydrophilic polymer, a polymer having a surface that can be made hydrophilic by drying, or a surfactant. Alternatively, the material that forms the holding region 14 may be such that the affinity thereof with respect to the fluid for forming the conductive pattern is increased by application of radiation including ultraviolet rays, an electron beam, gamma rays, etc.

The circuit board, which is produced from the conductive pattern-forming substrate 10, will be described below in relation to a production method therefor.

First, the conductive pattern-forming substrate 10 is prepared. More specifically, for example, the holding region-forming fluid is printed on one surface of the support 12, which is composed of a flame-resistant insulating material such as polyimide, heat-resistant PET, PEN, glass epoxy, bakelite, or ceramic. Flexographic printing, gravure printing, or the like may also be carried out during this step. Alternatively, a material such as a soluble polyimide, as described in Japanese Patent No. 4575725, which has a characteristic such that the affinity thereof with respect to the fluid is increased by radiation, may be used. Preferably, the material is applied and exposed to radiation in order to form the shape of the holding region 14. Depending on the intended use and the sensitivity of the material, the exposure method may be selected from among known methods such as surface exposure methods using photomasks and laser scanning methods.

The support 12 preferably has a flat shape, such as a plate shape, a sheet shape, or a roll shape, although the support 12 may have a bulky shape.

After drying, the wettability of the dried holding region-forming fluid with respect to the conductive pattern-forming fluid is higher than that of the support 12. For example, in the case that a polar ink is used as the conductive pattern-forming fluid, the holding region-forming fluid may have a surface energy that is higher than the surface energy of the conductive pattern-forming substrate 10 or the membrane formed thereon. On the other hand, for example, in the case that a non-polar ink is used as the conductive pattern-forming fluid, the holding region-forming fluid may have a surface energy that is lower than the surface energy of the conductive pattern-forming substrate 10 or the membrane formed thereon. In this manner, the holding region 14, which has a fluid wettability higher than the fluid wettability of the surrounding regions, can be formed.

As described above, the holding region-forming fluid preferably is used for forming the holding region 14, so as to have a surface energy that is higher by at least 5 mJ/m² than the surface energy of the surface of the conductive pattern-forming substrate 10 or the membrane formed thereon. More preferably, the surface energy of the holding region 14 is higher by at least 10 mJ/m², and even more preferably, is higher by at least 20 mJ/m², than the surface energy of the surrounding regions.

In the case of using liquid containing conductive particles as the conductive pattern-forming fluid, specific examples of the holding region-forming fluid include fluids containing a hydrophilic polymer, a polymer having a surface made hydrophilic upon drying, or a surfactant.

During preparation of the holding region 14, as shown in FIG. 2, the holding region-forming fluid may be printed to form connected octagonal lattice shapes. Thus, the first straight line group 18, the second straight line group 22, which is substantially perpendicular to the first straight line group 18, and the third straight line group 28 and the fourth straight line group 30, which form diagonal lines of the lattice shapes of the first straight line group 18 and the second straight line group 22, are formed.

The holding region 14 is formed by drying the holding region-forming fluid in order to obtain the conductive pattern-forming substrate 10.

Meanwhile, the conductive pattern-forming fluid is prepared. Metal particles containing copper, silver, gold, tin, zinc, or the like, carbon particles containing graphite, carbon nanotubes, fullerene, or the like, or organic conductive compound molecules comprising PEDOT/PSS or the like are dispersed in a dispersion medium such as water, an organic solvent, or an oil. Instead of a dispersion, a solution may be prepared by dissolving the material in an appropriate solvent. Alternatively, oxide particles containing copper oxide, silver oxide, or the like may be used as a starting material, and may be reduced and made conductive in a subsequent process. Nano-sized or micron-sized particles preferably are used during this step, because such particles can be readily dispersed or dissolved.

A thickener, a surfactant, or the like may be added to the conductive pattern-forming fluid in order to improve properties thereof such as viscosity, surface tension, or temperature. In this case, the difference in the fluid contact angle is further increased between the holding region 14 (affinity region) and the exposed surface (non-affinity region) of the support 12.

The fluid may be a commercially available ink for inkjet printing. Typical examples of inks include SW series (silver nanoparticle dispersions in an aqueous solution) and SR series (silver nanoparticle dispersions in an organic solution) available from Bando Chemical Industries, Ltd.

An ink, which is made up of a dispersion liquid containing fine particles of metal oxide or metal hydroxide, may be used. The ink will be described below.

### [1] Dispersion Liquid Containing Fine Particles of Metal Oxide or Metal Hydroxide

### (A) Composition and Size of Fine Particles of Metal Oxide or Metal Hydroxide

Examples of metals, which are used in the fine particles of the metal oxide or hydroxide, include Au, Ag, Cu, Pt, Pd, In, Ga, Sn, Ge, Sb, Pb, Zn, Bi, Fe, Ni, Co, Mn, Tl, Cr, V, Ru, Rh, Ir, and Al. Among oxides and hydroxides of such metals, oxides of Au, Ag, Cu, Pt, Pd, In, Ga, Sn, Ge, Sb, Pb, Zn, Bi, Fe, Ni, and Co preferably are used. Oxides of Ag and Cu (such as Ag₂O and Cu₂O) are particularly preferred, since such oxides can readily be reduced in order to generate a relatively stable metal. The average crystallite size of the fine metal oxide particles preferably is 1 to 100 nm, and more preferably, is 1 to 50 nm.

### (B) Production Method

A dispersion liquid containing fine particles made of the metal oxide or hydroxide may be prepared by neutralizing a metal salt solution (such as a chloride, bromide, sulfate, nitrate, or organic acid salt of the aforementioned metal) with a basic solution, by hydrolyzing a metal alkoxide, or by adding a reducing agent to a high-valence metal salt solution, so as to be reduced into a low-valence metal oxide or hydroxide. In the case of using an organic acid salt, specific examples of such organic acids preferably include formic acid, acetic acid, propionic acid, butyric acid, isobutyric acid, 2-ethylbutyric acid, pivalic acid, valeric acid, isovaleric acid, propiolic acid, lactic acid, caproic acid, caprylic acid, capric acid, benzoic acid, phthalic acid, salicylic acid, acrylic acid, methacrylic acid, ethylmethylacetic acid, allylacetic acid, and acetoacetic acid.

As necessary, surfaces of the fine particles made of the metal oxide or hydroxide may be modified in order to stabilize the dispersion liquid by adsorption of at least one of an adsorptive compound, a surfactant, and a hydrophilic polymer into the surfaces thereof.

As necessary, the dispersion liquid, which contains fine particles made of the metal oxide or hydroxide, may be subjected to a redispersion treatment. Accordingly, the fine particles made of the metal oxide or hydroxide may be precipitated by way of centrifugal separation or the like in the presence of at least one of an adsorptive compound and a surfactant, washed, and then redispersed in another dispersion medium. The dispersion liquid may be subjected to a purification or concentration treatment such as a desalination treatment.

### (a) Adsorptive Compound

As the adsorptive compound, a compound having a functional group such as -SH, -CN, -NH₂, -SO₂OH, -SOOH, - OPO(OH)₂, or -COOH can be used effectively. Preferably, the adsorptive compound is a compound having an -SH group (such as dodecanethiol or L-cysteine), or a compound having an - NH₂ group (such as octylamine, dodecylamine, oleylamine, oleic acid amide, or lauric acid amide). In the case of using a hydrophilic colloid, the adsorptive compound preferably includes a hydrophilic group such as -SO₃M or - COOM (where M represents a hydrogen atom, an alkali metal atom, an ammonium moiety, etc.)

### (b) Surfactant

As the surfactant, an anionic surfactant (such as sodium bis(2-ethylhexyl)sulfosuccinate or sodium dodecylbenzenesulfonate), a nonionic surfactant (such as an alkyl ester of polyalkylglycol or an alkyl phenyl ether), a fluorine-based surfactant, or the like can be used.

### (c) Hydrophilic Polymer

A hydrophilic polymer such as hydroxyethylcellulose, polyvinyl pyrrolidone, polyvinyl alcohol, or polyethylene glycol may be added to the colloidal dispersion.

### (d) Additive Amount

The amount by mass of at least one of the adsorptive compound, the surfactant, and the hydrophilic polymer, preferably is 0.01 to 2 times, and more preferably, is 0.1 to 1 time as large as the amount of the fine metal oxide particles. Preferably the surface of the fine metal oxide particle is coated with a layer of at least one of the adsorptive compound, the surfactant, and the hydrophilic polymer, at a thickness of 0.1 to 10 nm. The surface of the fine metal oxide particle may be coated in a non-uniform manner, and only a portion of the surface may be coated.

Surface modification of the fine metal oxide particles by an organic compound, such as the adsorptive compound, the surfactant, or the hydrophilic polymer, can be detected by chemical analysis, or by observation using a high-resolution TEM such as an FE-TEM, for thereby evaluating the consistency of the distance between the fine metal oxide particles.

### (e) Solvent

Examples of solvents for the metal oxide or hydroxide dispersion (as well as solvents for the ink, to be described later) include:
(1) esters such as butyl acetate and cellosolve acetate;
(2) ketones such as methyl ethyl ketone, cyclohexanone, methyl isobutyl ketone, and acetylacetone;
(3) chlorinated hydrocarbons such as dichloromethane, 1,2-dichloroethane, and chloroform;
(4) amides such as dimethylformamide;
(5) aliphatic hydrocarbons such as cyclohexane, heptane, octane, isooctane, and decane;
(6) aromatic hydrocarbons such as toluene and xylene;
(7) ethers such as tetrahydrofuran, ethyl ether, and dioxane;
(8) alcohols such as ethanol, n-propanol, isopropanol, n-butanol, diacetone alcohol, ethylene glycol, 2,5-hexanediol, 1,4-butanediol, cyclohexanol, cyclopentanol, and cyclohexenol;
(9) fluorine-containing solvents such as 2,2,3,3-tetrafluoropropanol;
(10) glycol ethers such as ethylene glycol monomethyl ether, ethylene glycol monoethyl ether, and propylene glycol monomethyl ether;
(11) alkylaminoalcohols such as 2-dimethylaminoethanol, 2-diethylaminoethanol, 2-dimethylaminoisopropanol, 3-diethylamino-1-propanol, 2-dimethylamino-2-methyl-1-propanol, 2-methylaminoethanol, and 4-dimethylamino-1-butanol;
(12) carboxylic acids such as butyric acid, isobutyric acid, 2-ethylbutyric acid, pivalic acid, valeric acid, propionic acid, lactic acid, acrylic acid, methacrylic acid, propiolic acid, ethylmethylacetic acid, and allylacetic acid;
(13) amines such as diethylenetriamine and ethylenediamine; and
(14) water.

One or a combination of two or more solvents may be selected, depending on the dispersion stability of the metal oxide or hydroxide, the solubility of a reducing agent, the stability of the reducing agent against oxidation, viscosity, etc. Furthermore, the solvent (common solvent) preferably is a solvent in which the metal oxide or hydroxide exhibits excellent dispersion and the reducing agent exhibits excellent solubility.

### (C) Dispersion Liquid

The concentration of fine particles of the metal oxide or hydroxide in the dispersion liquid preferably is 1% to 80% by mass, and more preferably, is 5% to 70% by mass, in the corresponding metal concentration. The dispersion liquid may contain one type or several types of fine particles. The metal that constitutes the fine particles of the metal oxide or hydroxide may have one or more valence numbers. Fine particles of the metal oxide or hydroxide may be used in combination with inorganic fine particles of SiO, SiO₂, TiO₂, or the like, or a polymer (which may be in a fine particle state or another state) in order to control insulative/conductive properties of the energy-irradiated area and the non-irradiated area. The diameter of the fine particles of the metal oxide or hydroxide in the dispersion liquid is not limited, and generally is selected with the aim of forming a colloid. The particle diameter preferably is 1 to 100 nm, and more preferably, is 1 to 50 nm.

### [2] Ink

The above-described dispersion liquid, which contains fine particles of the metal oxide or hydroxide, can be used without modification as an ink. In the case that a reduction reaction for generating metal cannot be carried out readily in the dispersion liquid, which contains fine particles of the metal oxide or hydroxide, even under irradiation of energy thereto, a reducing agent may be added to the dispersion liquid.

The reducing agent, which is used for reducing the fine particles of the metal oxide or hydroxide, may be an inorganic or organic reducing agent. Examples of inorganic reducing agents include NaBH₄, hydrazine, and hydroxylamine. Examples of organic reducing agents include (i) hydrazine compounds having a hydrazine group such as phenylhydrazine, (ii) amines such as p-phenylenediamine, ethylenediamine, and p-aminophenol, (iii) hydroxylamine compounds having an acyl group, an alkoxycarbonyl group, or the like on a nitrogen atom, (iv) aminoalcohols such as 2-dimethylaminoethanol, 2-diethylaminoethanol, 2-aminoethanol, diethanolamine, and 2-amino-2-methyl-1-propanol, (v) diols such as hydroquinone, catechol, 1,4-butanediol, and ethylene glycol, and (vi) organic reducing agents represented by the general formula X-(A=B)ₙ-Y (in which A and B represent a carbon or nitrogen atom, respectively, X and Y each represent an atom group bonded to A or B on an atom having an unshared electron pair, and n represents 0 to 3), tautomers thereof, and compounds capable of thermally generating such organic reducing agents.

The reducing agent may be used alone or in a combination of two or more reducing agents. Preferably, plural reducing agents are used in combination depending on the selective reduction actions on the metal oxide or hydroxide. The reducing agent may be used also as the organic solvent, as necessary.

In the compound noted in item (vi) above, which is represented by the general formula X-(A=B)ₙ-Y, the atom having an unshared electron pair preferably is an oxygen atom, a nitrogen atom, a sulfur atom, or a phosphorus atom, and more preferably, is an oxygen atom or a nitrogen atom. Each of the atom groups X and Y in which the atom is contained preferably is OR₁, NR₁R₂, SR₁, or PR₁R₂, in which R₁ and R₂ represent a hydrogen atom or a substituent thereof, respectively. The substituent preferably is a substituted or unsubstituted alkyl group having 1 to 10 carbon atoms, or a substituted or unsubstituted acyl group having 1 to 10 carbon atoms.

The integer variable n preferably is 0 to 3, more preferably, is 0 to 2, and most preferably, is 0 to 1. On the condition that n is 2 or greater, the repeating units may contain different atoms of A and B. A and B, X and A, and Y and B may be bonded together in order to form a ring structure. Such a ring structure preferably is a 5-member or 6-member ring structure. The ring structure may form a condensed ring, and preferably, is a 5-member to 6-member ring structure in view of forming the condensed ring.

The reducing agent preferably exhibits a low electrical conductivity after the reduction reaction has been carried out. More specifically, an organic reducing agent, hydrazine, and hydroxylamine preferably are used as the reducing agent, because such reducing agents do not generate residual metal ions. In the case that a large amount of the reducing agent remains as a residue after the reduction reaction, the residue tends to cause an adverse effect on the conductivity of the wiring. Therefore, preferably, a reducing agent is used that generates only a small amount of residue. It is further preferred that the reducing agent exhibits a volatile (sublimable) property after the reduction reaction, or is decomposed in order to exhibit a volatile property after the reduction reaction.

For similar reasons, preferably, the fine particles of the metal oxide or hydroxide are capable of being reduced using a small amount of the reducing agent. Thus, the reducing agent preferably has a low molecular weight. The molecular weight of the reducing agent preferably is 500 or less, more preferably, is 300 or less, and most preferably, is 200 or less.

Specific examples of reducing agents are shown below, which can be used for reducing the fine particles of the metal oxide or hydroxide. However, the ink is not limited to these examples.

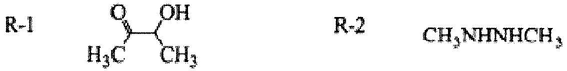

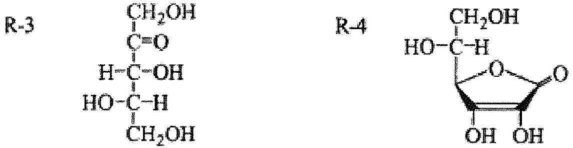

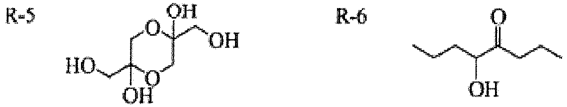

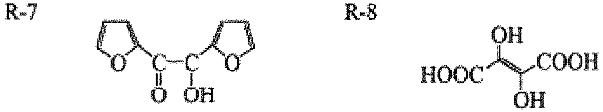

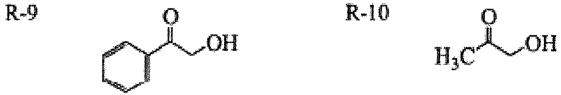

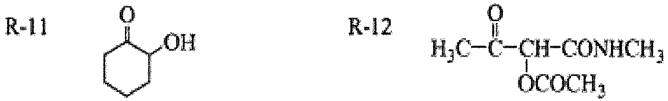

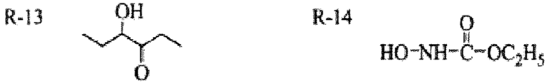

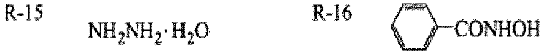

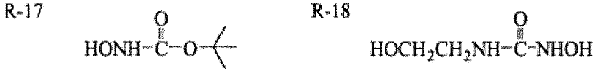

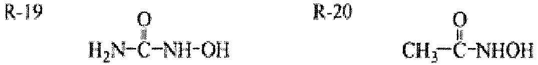

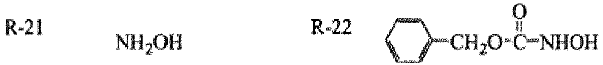

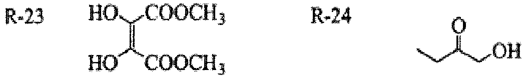

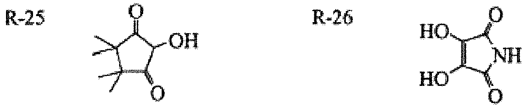

The fine particles of the metal oxide or hydroxide and the reducing agent preferably are used in combination in such a manner that (a) the reducing agent has substantially no function of reducing the fine particles at ordinary temperature yet has a high reducing function under irradiation of energy thereto, and the reducing agent and the fine particles are contained in a single dispersion liquid (in order to obtain a one-component ink), or (b) the reducing agent has a reducing function (the reducing agent may have a high or low reducing function at ordinary temperature, and has a high reducing function under irradiation of energy thereto), and a dispersion of fine particles (which either contains or does not contain the reducing agent) and a solution of the reducing agent are prepared separately (in order to obtain a two-component ink).

In the case that the fine metal oxide particles are not reduced significantly by the reducing agent even under irradiation of energy thereto, or on the condition that it is necessary to enhance the reducing function of the reducing agent under irradiation of energy, a reduction promoter such as a base or a base precursor may be added to the dispersion liquid containing fine particles of the metal oxide or hydroxide, or may be added to another liquid (i.e., the reducing agent or a solution thereof). The base or the base precursor may have a reducing function.

Thus, preferably, the reducing agent exhibits a low rate of reduction of the fine particles of the metal oxide or hydroxide at ordinary temperature, but exhibits a high rate of reduction under irradiation of energy. The preferred heating temperature, which is attained during irradiation of energy, depends on the irradiation time, and thus the preferred heating temperature cannot be determined categorically. In view of the heat resistance of the substrate or the device, the increase in temperature thereof due to heat diffusion preferably is approximately 300° C or lower, and more preferably, is approximately 250° C or lower. Therefore, preferably, the reducing agent exhibits a sufficient reducing function, so as to reduce the fine particles of the metal oxide or hydroxide at a temperature of approximately 300° C or lower. In the case that the reducing agent exhibits a high reducing function even at room temperature and is used in the two-component ink described in item (b) above, the fine particles are reduced in order to generate the metal immediately after mixing of the two liquids. Therefore, in this case, it is not necessary to carry out irradiation of energy after the two liquids have been mixed.

As described hereinafter, the dispersion liquid, which contains fine particles of the metal oxide or hydroxide, the reducing agent, or the mixture thereof, can be used suitably as an ink for drawing a pattern in an inkjet printer, a dispenser, etc. Therefore, as necessary, a solvent may be added to control the viscosity of the ink. Examples of suitable solvents for the ink include the above-described solvents.

As necessary, depending on the intended use, an additive such as an antistatic, an antioxidant, a UV absorber, a plasticizer, a carbon nanoparticle, a dye, or a heat-hardening resin (e.g., a heat-hardening phenol resin) may further be added to at least one of the dispersion liquid containing fine particles of the metal oxide or hydroxide and the reducing agent or the solution thereof.

In the case of using a dispersion liquid containing fine particles of the metal oxide or hydroxide, the reducing agent or a solution thereof, or a mixture thereof, which serves as an ink for drawing a pattern in the inkjet printer, the dispenser, or the like, it is important to control the viscosity of the ink. On the condition that the ink has an excessively high viscosity, it is difficult for the ink to be ejected from a nozzle. On the other hand, on the condition that the ink has an excessively low viscosity, the formed image may be blurred. More specifically, the viscosity of the ink preferably is 1 to 100 cP, and particularly preferably, is 5 to 30 cP. The surface tension of the ink preferably is 25 to 80 mN/m, and particularly preferably, is 30 to 60 mN/m.

The ink is a dispersion in a polar solvent such as water or alcohol, or a dispersion in a non-polar solvent such as tetrahydrofuran (THF) or hexane. Hereinafter, the former dispersion is referred to as a polar ink, whereas the latter dispersion is referred to as a non-polar ink.

Typical examples of polar inks include FLOWMETAL SW-1000 series (dispersions containing silver nanoparticles and a dispersing agent in water, available from Bando Chemical Industries, Ltd.), silver nanoinks CCI-300 (available from Cabot Corporation), and copper oxide inks ICI-003 (available from NovaCentrix Corporation). Typical examples of non-polar inks include FLOWMETAL SR-2000 series (silver nanoparticle dispersions in a solvent, available from Bando Chemical Industries, Ltd.) and copper nanoparticle inks (available from Intrinsic), and further include etching resist inks that make use of an acrylic monomer having an ultraviolet radical polymerizability.

Thereafter, the above fluid (i.e., a polar or non-polar ink) is dropped onto a portion of the holding region 14 by a non-contact printing method such as an inkjet printing method.

During this step, in the case that a polar ink is used as the fluid, the polar ink spreads readily in a high-surface-energy region on the conductive pattern-forming substrate 10. Therefore, in this case, in the conductive pattern-forming substrate 10, the holding region 14, which contains the straight line groups that act to hold the polar ink, has a surface energy that is significantly higher than the surface energy of the surrounding regions.

On the other hand, in the case that a non-polar ink is used as the fluid, the non-polar ink is readily spread in a low-surface-energy region on the conductive pattern-forming substrate 10. Therefore, in this case, on the conductive pattern-forming substrate 10, the holding region 14, which contains the straight line groups that act to hold the non-polar ink, has a surface energy that is significantly lower than the surface energy of the surrounding regions.

The structure of the conductive pattern-forming substrate 10 is selected appropriately in the above manner depending on the characteristics of the fluid. Therefore, the fluid wettability of the holding region 14 is higher than the fluid wettability of the surrounding regions. Consequently, droplets of the fluid that land on the holding region 14 spread only slightly while being held in the holding region 14.

Even in the case that droplets of the fluid land on positions spaced relatively far away from each other, the droplets spread in the above-described manner, such that ends of the droplets become connected with each other. Furthermore, even in the case that a droplet of the fluid lands on a position that differs from the desired landing position, the droplet spreads and reaches the desired landing position. Consequently, the droplets of the fluid become connected with each other, whereby a continuous conductive pattern is formed in the holding region 14 after the fixation treatment. Thus, breakage of the conductive pattern is prevented, and variation in size in the width direction of the conductive pattern is reduced.

As described above, the holding region 14 containing the straight line groups is formed on the surface of the support 12, and the surface energy of the holding region 14 differs significantly from the surface energy of the surrounding regions. In a case where droplets of the fluid become attached to the holding region 14, the droplets spread out along the straight line of the holding region 14. Consequently, breakage and dimensional variation can be reduced, thereby enabling a high-quality conductive pattern to be obtained.

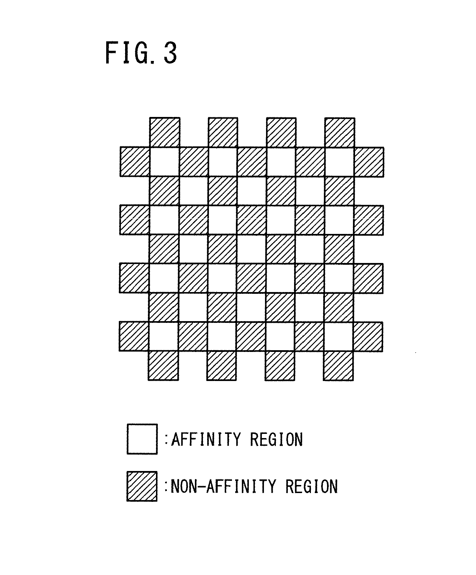

In the case that the affinity regions and the non-affinity regions are arranged in a checkered (checkered flag) pattern, as shown in FIG. 3, it is difficult for fluid droplets to become attached thereto in a straight line. Thus, it is difficult for a long straight line to be drawn.

In contrast, according to the first embodiment, even in the case that a portion of the fluid lands on the non-affinity region, the fluid is repelled by the non-affinity region and is not held in the non-affinity region. Therefore, it is possible for a straight line to be drawn efficiently having a predetermined size in the width direction.

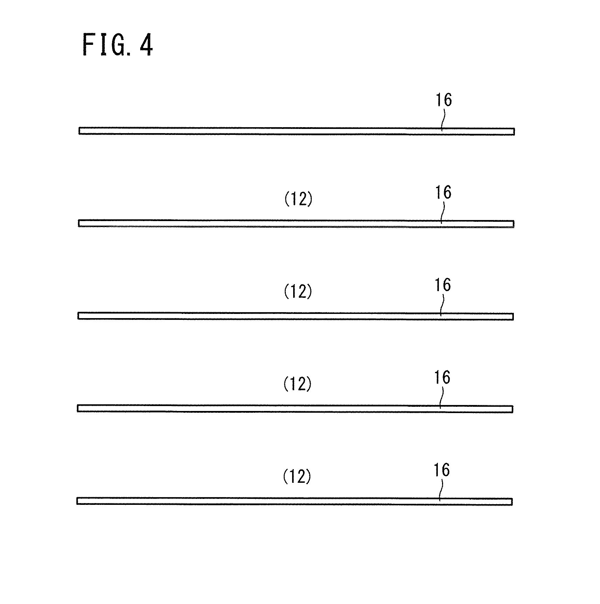

In the case that long non-affinity regions and long affinity regions are arranged alternately, as shown in FIG. 4, a bent portion cannot be formed in the conductive pattern, although a long straight line can easily be drawn.

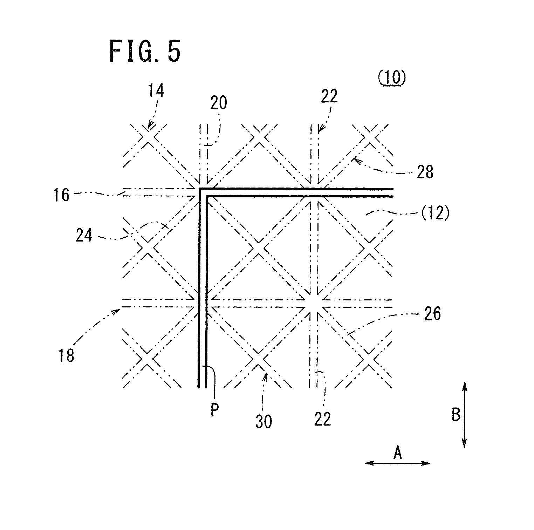

According to the first embodiment, for example, as shown in FIG. 5, a conductive pattern P, which extends in the A direction and then extends in the B direction, can be formed by printing the fluid on the first straight line 16, and then printing the fluid on the second straight line 20.

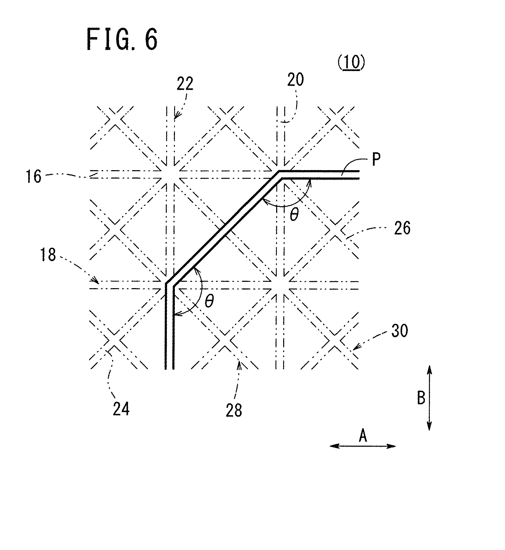

In the case that the direction of the conductive pattern P is changed from the A direction to the B direction, preferably, as shown in FIG. 6, the fluid is printed on the first straight line 16, the third straight line 24, and the second straight line 20 in this order. In this case, the bending angle θ of the conductive pattern P, which is obtained upon drying of the printed fluid, is an obtuse angle. A conductive pattern P that is bent at such an angle is expected to be more excellent in conductive properties than a conductive pattern P that is bent at a right angle as shown in FIG. 5.

After the fluid has been printed in the above manner, the fluid may be subjected to a heat treatment, as necessary. During such a heat treatment, for example, the fluid may be irradiated with a microwave plasma, an electron beam, or a flash light. In the case that a two-component hardening liquid is used as the fluid, it is not necessary to carry out such a heat treatment.

In the above step, the fluid is dried and the particles in the fluid are sintered, or alternatively, the fluid is hardened. Consequently, the conductive pattern is formed to thereby obtain the circuit board.

Although in the above embodiment, as shown in FIG. 2, the holding region 14 contains octagonal lattice shapes that are formed repeatedly, the holding region 14 is not particularly limited to such a pattern. For example, as shown in FIG. 7, the holding region 14 may contain simple square lattice shapes, which are formed only by the first straight line group 18 and the second straight line group 22. In this case, four straight lines extend radially from each of the intersections (other than the intersections on the edge).

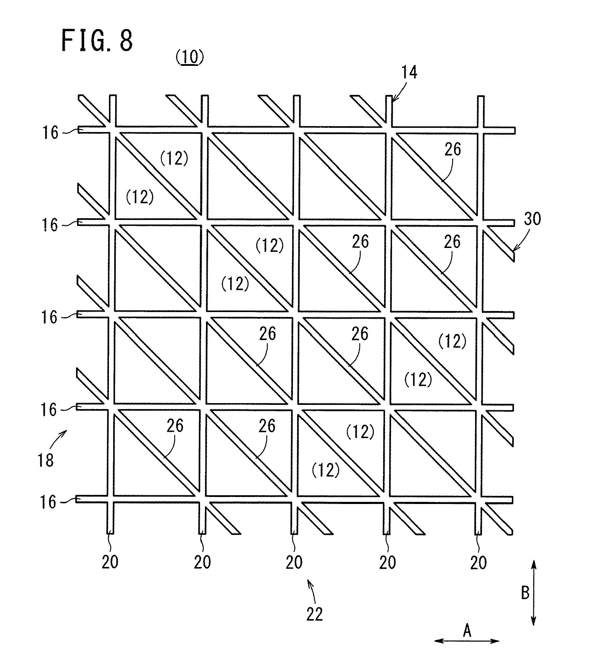

Alternatively, as shown in FIG. 8, the holding region 14 may contain simple square lattice shapes each containing a single diagonal line. In this case, the holding region 14 contains the first straight line group 18, the second straight line group 22, and the fourth straight line group 30, such that six straight lines extend radially from each of the intersections (other than the intersections on the edge).

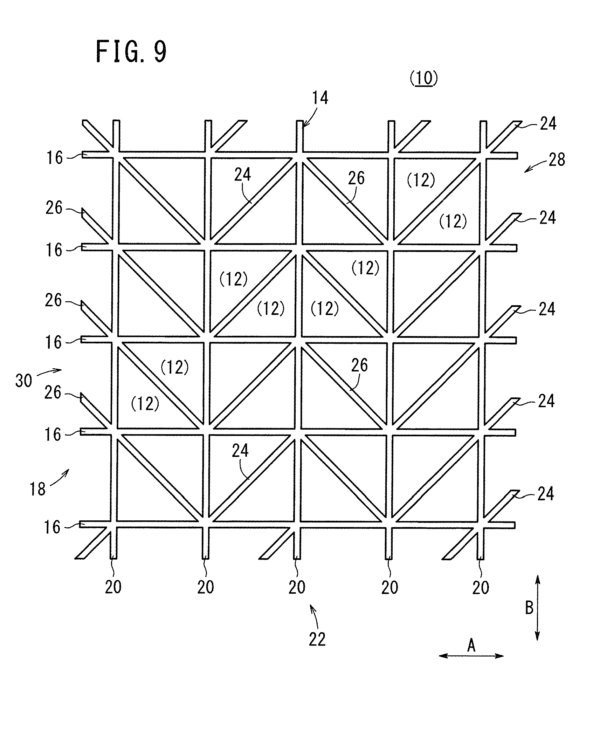

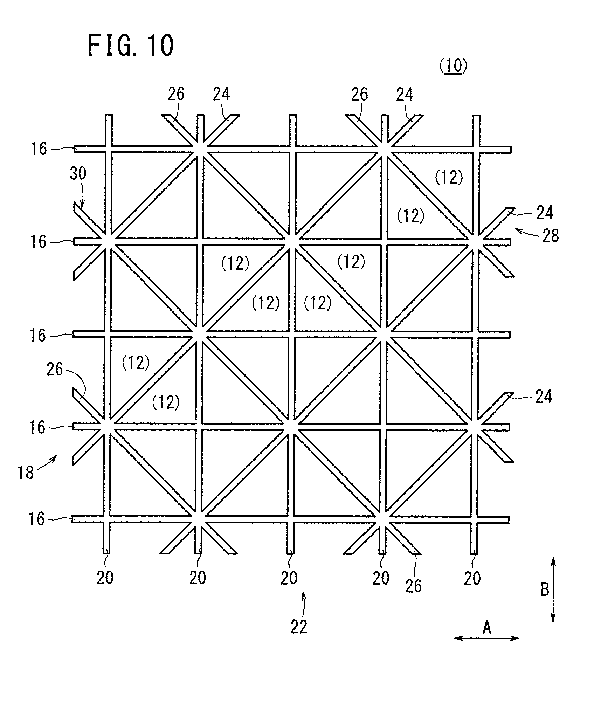

Furthermore, as shown in FIGS. 9 and 10, the holding region 14 may have diagonal lines made up of the fourth straight line group 30 and the third straight line group 28 in simple square lattice shapes.

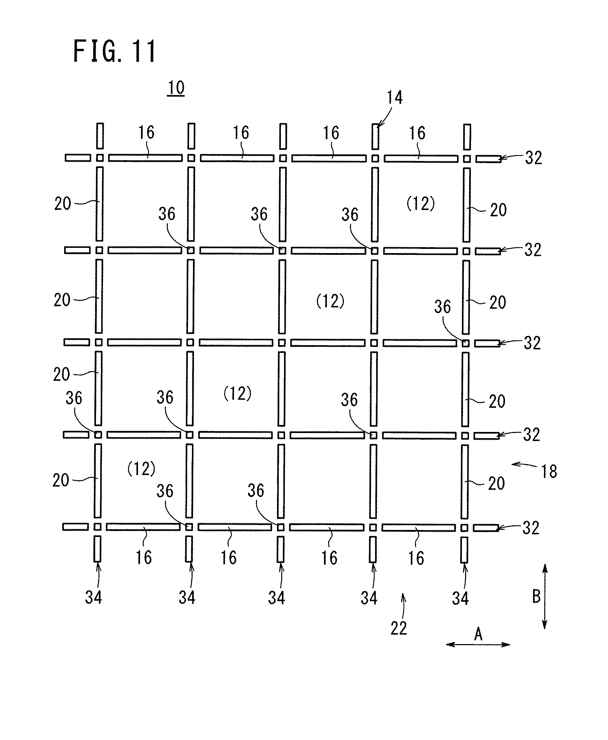

Furthermore, as shown in FIG. 11, at least a plurality of the first straight lines 16 or a plurality of the second straight lines 20 may be arranged on one axial line so as to form an apparent broken line. An apparent broken line, which is formed by arranging a plurality of the first straight lines 16 along one axial line, and an apparent broken line, which is formed by arranging a plurality of the second straight lines 20 along one axial line, will be referred to hereinafter as a first broken line 32 and a second broken line 34, respectively.

Broken portions of the first broken line 32 (i.e., gaps between the first straight lines 16 arranged along one axial line) correspond to broken portions of the second broken line 34 (i.e., gaps between the second straight lines 20 arranged along one axial line). Thus, in this case, the aforementioned intersections between the first straight lines 16 and the second straight lines 20 are removed. In such a description, the shape also is considered as a lattice shape. Further, the space formed by removing the intersection also is referred to as an intersection.

A dot-shaped holding region 36 is formed at the broken portion (i.e., the intersection or the space formed by removing the intersection). Therefore, an apparent dashed-dotted line is formed by each of the combination of two first straight lines 16 and the dot-shaped holding region 36, and the combination of two second straight lines 20 and the dot-shaped holding region 36.

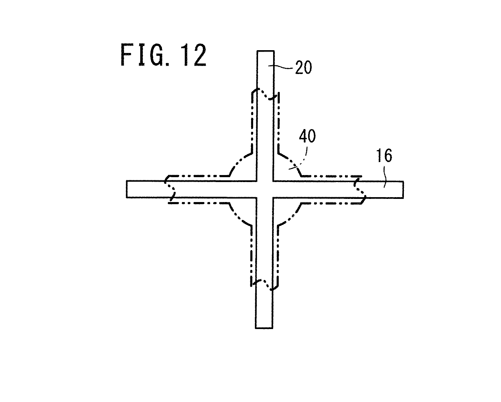

In the case that the first straight line 16 and the second straight line 20 intersect one another, and the conductive pattern is formed on both of the first straight line 16 and the second straight line 20, the fluid that is printed on the first straight line 16 may overlap with the fluid that is printed on the second straight line 20 at the intersection. Therefore, as shown in FIG. 12, an excessive amount of fluid may be applied at the intersection, such that fluid 40 may become blurred.

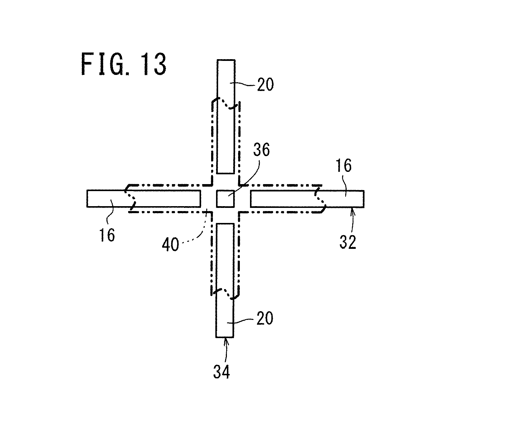

In contrast, in the lattice shape shown in FIG. 11, the gap is formed at the position (intersection) at which the first straight line 16 and the second straight line 20 cross one another. Therefore, as shown in FIG. 13, in the case that fluid is printed on both of the first broken line 32 and the second broken line 34 that intersects therewith, the overlapping fluid 40 spreads over the gap (non-holding region) between the first straight lines 16, 16 and the second straight lines 20, 20. Thus, breakage of the fluid can be prevented.

In addition, the dot-shaped holding region 36 is formed in the gap. Therefore, the fluid 40 spreads through the dot-shaped holding region 36 and over the gap formed between the first straight lines 16 and the second straight lines 20. Thus, breakage of the fluid can be prevented more easily.

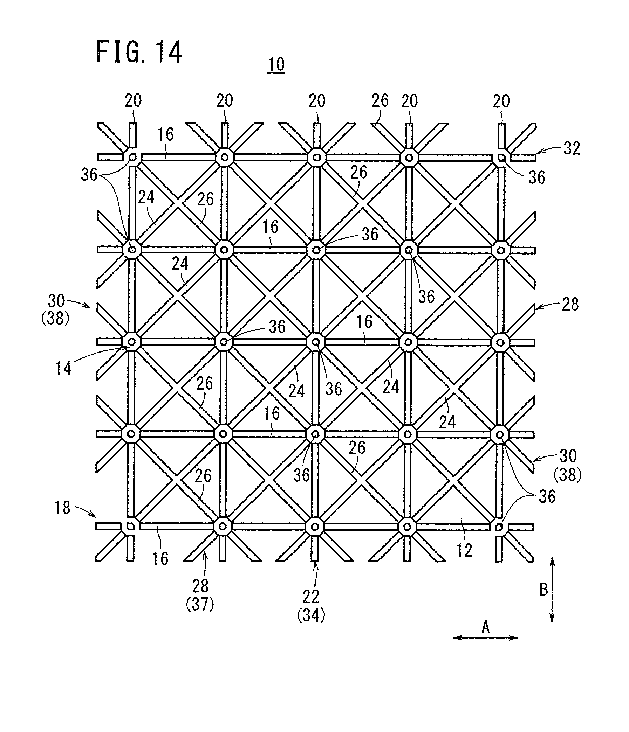

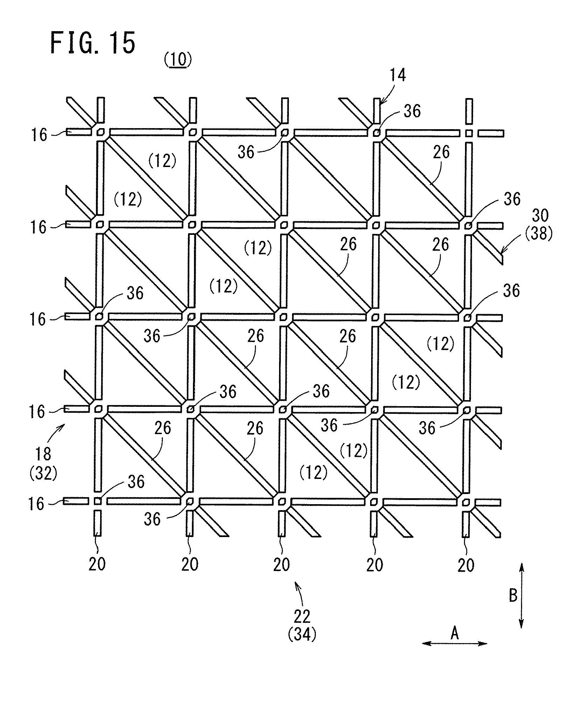

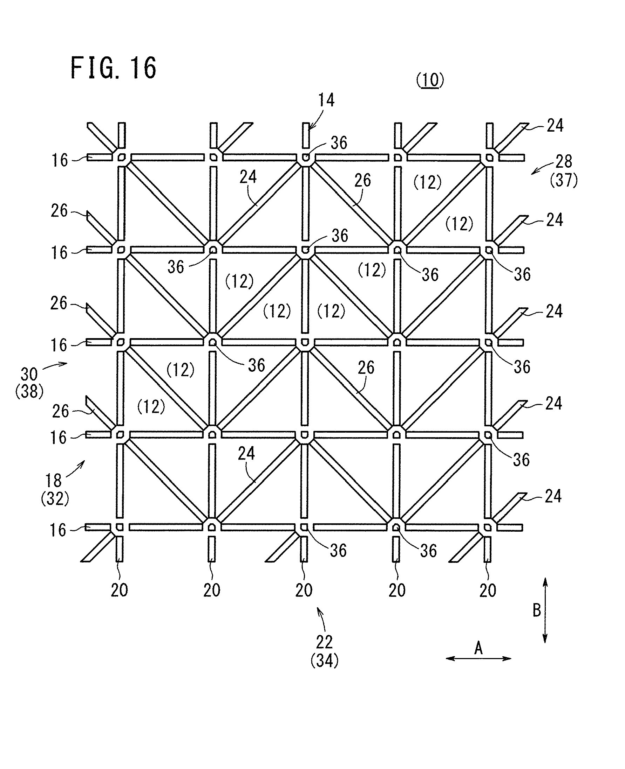

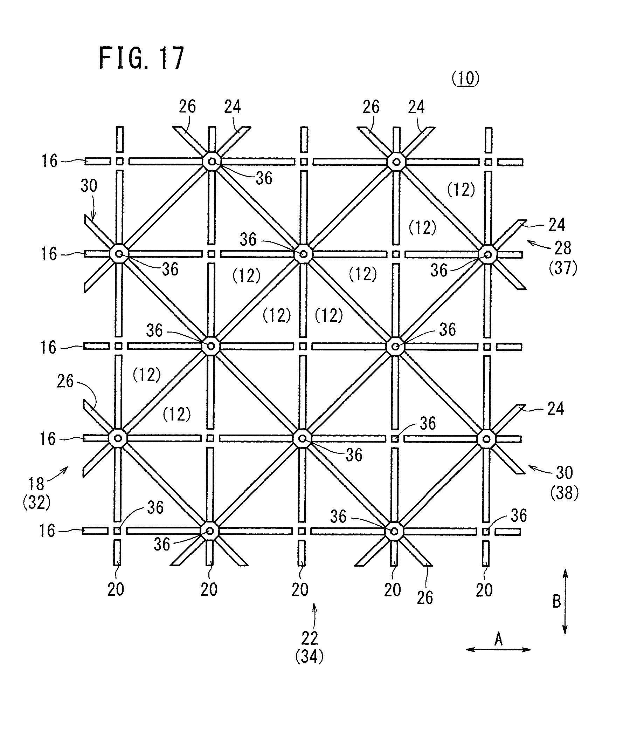

Similarly, the third straight lines 24 and the fourth straight lines 26 shown in FIGS. 2 and 8 to 10 may be arranged to form apparent broken lines. An apparent broken line, which is formed by arranging a plurality of the third straight lines 24 on one axial line, and an apparent broken line, which is formed by arranging a plurality of the fourth straight lines 26 on one axial line, will be referred to hereinafter as a third broken line 37 and a fourth broken line 38, respectively. Patterns containing the holding regions 14, 36, which correspond to FIGS. 2 and 8 to 10, are shown respectively in FIGS. 14 to 17.

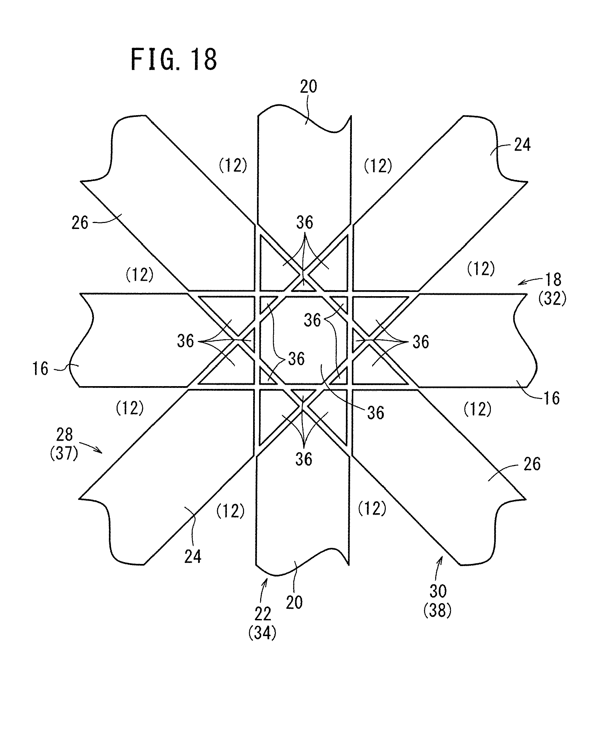

As shown in FIG. 18, the first straight line 16, the second straight line 20, the third straight line 24, and the fourth straight line 26 may be divided so as to form a gap having an eight-rayed star shape at the intersection thereof. In this case, for example, in a case where fluid is printed on the third straight line 24 (the third broken line 37) and then on the first straight line 16 (the first broken line 32) along the arrow A, the fluid can more easily be prevented from flowing into an undesired broken line.

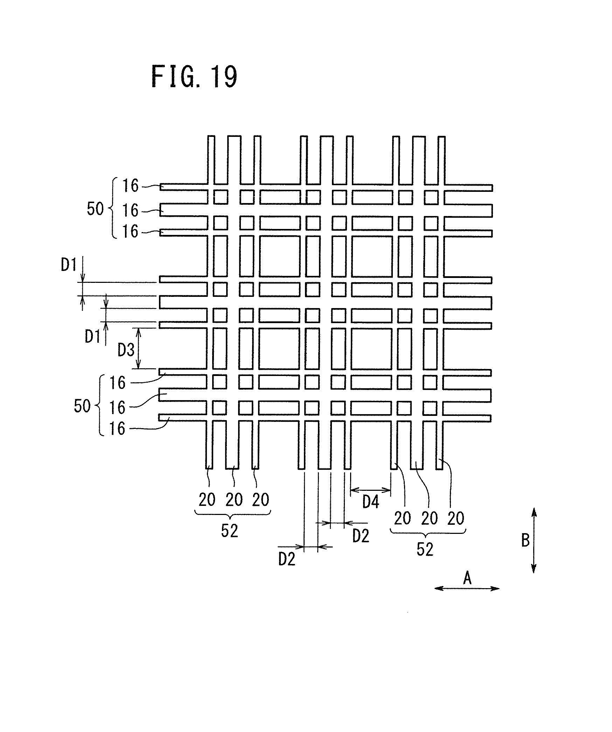

As shown in FIG. 19, the first straight lines 16 or the second straight lines 20 may be arranged in closer proximity to each other to thereby form an assembly. In FIG. 19, three first straight lines 16 are arranged to form one first assembly 50. Among the three first straight lines 16 that make up the first assembly 50, the size of the central line is larger than the sizes of the other two lines in the width direction. Similarly, three second straight lines 20 are arranged to form one second assembly 52. Among the three second straight lines 20 that make up the second assembly 52, the size of the central line is larger than the size of the other two lines in the width direction. Also, in this case, a lattice shape is formed by the first assembly 50 and the second assembly 52.

In the first assembly 50, the distance D1 between the central first straight line 16 and each of the other two first straight lines 16 is equal to or less than the dot diameter of the fluid. Similarly, in the second assembly 52, the distance D2 between the central second straight line 20 and each of the other two second straight lines 20 is equal to or less than the dot diameter of the fluid.

For example, in the first assembly 50 or the second assembly 52, fluid may be printed on only one of the two lines that lie adjacent to the central line, thereby forming a thinnest conductive pattern. Alternatively, in the first assembly 50 or the second assembly 52, fluid may be printed on only the central line, so as to form a conductive pattern with a relatively large size in the width direction.

Furthermore, fluid may be applied between the central line and one of the two adjacent lines. The region between the central line and the adjacent line does not act as a holding region. However, as described above, since the distances D1, D2 are equal to or less than the dot diameter of the fluid, the fluid spreads in both the central line and the adjacent line.

In addition, fluid may also be applied between the central line and the other of the two adjacent lines. In this case, the fluid spreads in the width direction over the first assembly 50 or the second assembly 52 so as to form the conductive pattern.

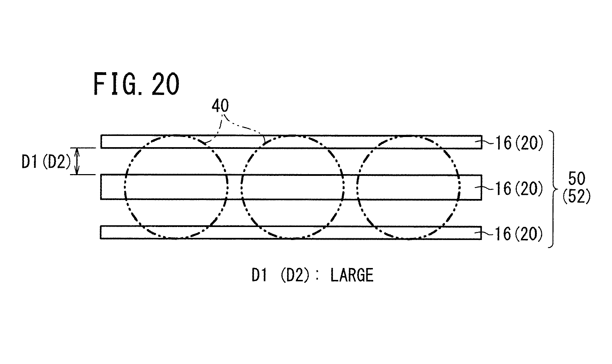

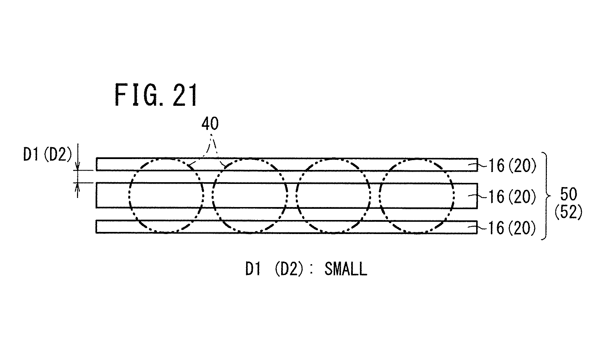

Furthermore, as made clear from a comparison of FIGS. 20 and 21, the size in the width direction of the applied fluid 40 (i.e., the size in the width direction of the conductive pattern) can be controlled by changing the distance D1 (D2) between the central line and each of the two adjacent lines. In FIGS. 20 and 21, the fluid 40 is not spread in the longitudinal direction of the first straight line 16 (the second straight line 20).

In the case that the first assembly 50 and the second assembly 52 are formed in the above manner, the size in the width direction of the conductive pattern can be controlled with great ease.

The distance D3 between the first assemblies 50, 50 and the distance D4 between the second assemblies 52, 52 are equal to or greater than the dot diameter of the fluid. Therefore, even in the case that the fluid is applied to a portion between the first assemblies 50, 50 or between the second assemblies 52, 52, the fluid is prevented from spreading over the first assemblies 50, 50 or the second assemblies 52, 52.

As necessary, the formed conductive pattern may be subjected to a plating treatment. By such a treatment, a conductive layer (generally a conductive metal layer) is stacked on the conductive pattern that is derived from the fluid, such that the cross-sectional area of the conductive path is increased. Thus, the plating treatment is suitable for producing a circuit board for an electrical circuit to which a large current may be applied.

Although according to the first embodiment, the holding region-forming fluid is printed on the support 12 in order to form the affinity region, the conductive pattern may be formed by deposition and exposure of a conductive metal layer. A second embodiment including this process will be described below.

A circuit board according to the second embodiment may be produced in the following manner.

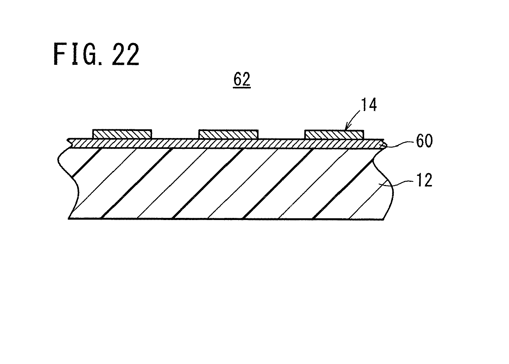

First, a conductive metal layer 60 (see FIG. 22) is formed by a plating process or the like on the support 12, which is composed of the insulating material. Preferably, from the viewpoints of conductivity, cost, and etching resistance, copper is used as the metal of the conductive metal layer 60. The thickness of the conductive metal layer 60 may be appropriately selected from within a range of 1 µm to 1 mm, depending on the required m current capacity, the wiring density, etc. In general, the thickness preferably is 10 to 100 µm, and more preferably, is 15 to 50 µm.

Thereafter, the holding region 14 having the lattice shape is formed on the conductive metal layer 60 in the same manner as the first embodiment. Of course, in this step, the holding region-forming fluid may be printed (e.g., inkjet printed) thereon. Further, in this step, as shown in FIG. 22, a conductive pattern-forming substrate 62, which includes the conductive metal layer 60 and the holding region 14 formed in this order on one surface of the support 12, is prepared. In the present structure, the holding region 14 acts as an affinity region, whereas the surface of the conductive metal layer 60, which is exposed from the holding region 14, acts as a non-affinity region.

In order to produce the circuit board from the conductive pattern-forming substrate 62, an etching resist agent is printed on a portion of the holding region 14. The printed agent has a shape corresponding to the desired conductive pattern. For example, a non-contact printing method such as an inkjet printing method may also be used during this step.

The etching resist agent may comprise a fluid containing a polymerizable polymer. The etching resist agent exhibits a significantly small contact angle on the holding region 14, and is repelled by the non-affinity region of the conductive metal layer 60. Thus, a predetermined portion in the holding region 14 is covered by the etching resist agent, whereas the conductive metal layer 60 is not covered therewith. As will be described hereinafter, the conductive pattern is formed on the portion that is covered with the etching resist agent. Therefore, in this case, the fluid that forms the conductive pattern serves as the etching resist agent.

Then, the etching resist agent is hardened by application of ultraviolet rays, heat, etc. Of course, both ultraviolet rays and heat may be used in combination. During this step, an etching resist mask is formed.

Specific examples of suitable etching resist agents include a masking resist ink PMA-2100P-001 (trade name) available from JNC Corporation. In this case, for example, the etching resist agent may be ejected under a substrate temperature of 25° C and a head temperature of 70° C, and the etching resist agent may be exposed to a metal halide UV lamp at 250 mJ/cm².

The stack, which is made up of the support 12, the conductive metal layer 60, the holding region 14, and the etching resist mask, is immersed in an appropriate etching liquid such as a heated aqueous ferric chloride solution. Consequently, except for the portion that is covered with the etching resist mask, the holding region 14 and the conductive metal layer 60 are removed from the stack, whereby the surface of the support 12 is exposed.

Next, the etching resist mask and the holding region 14 disposed immediately therebelow are removed. For example, the etching resist mask and the holding region 14 may be removed by immersing the stack in an alkaline liquid or the like, or by a mechanical removal process such as a polishing process.

Following such removal, the conductive pattern of the conductive metal layer 60 is exposed. The etching resist agent (mask) is formed in a shape corresponding to the conductive pattern. Therefore, during this step, a conductive pattern having a desired shape is obtained, thereby producing a circuit board having the conductive pattern.

Of course, in the second embodiment as well, the holding region 14 may be formed in a lattice shape (or dot shape), as shown in FIGS. 2, 7 to 11, and 14 to 19.

Furthermore, it should be understood that an additional conductive layer (such as another conductive metal layer) may be formed on the conductive metal layer 60 by a plating treatment, in the same manner as in the first embodiment.

The circuit board, which is obtained in this manner, may be subjected to an post-treatment, such as a piercing treatment or a solder resist treatment, as necessary. Further, a component such as a resistor, a capacitor, or an IC component may be attached to the circuit board to produce a circuit.

In the above first and second embodiments, the regions exhibit significantly different wettabilities (affinities) with respect to the fluid that forms the conductive pattern, whereby landing interference can be prevented.

In a non-contact printing method such as an inkjet printing method, the printing pattern can be changed in each printing process. In other words, different conductive patterns can be formed in succession. Therefore, various types of circuit boards can easily be produced from the conductive pattern-forming substrate 10, 62 of the first or second embodiment. Thus, the conductive pattern-forming substrate 10, 62 can suitably be used for production of a wide variety of circuit boards in small quantities.

In addition, even in the case that the landed fluid is positioned incorrectly, the fluid can spread readily along the holding region 14 in order to form a conductive pattern with a desired size in the width direction.

With a view toward preventing fluid from flowing in a wrong direction at the intersection, it is effective that a fluid of a given fluidity is made to land on the intersection, whereas another fluid having a different fluidity is made to land on other portions apart from the intersection. Thus, a high-viscosity fluid may be made to land on the intersection, while a low-viscosity fluid may be made to land on portions other than the intersection. By way of inkjet printing, the high-viscosity fluid may be ejected from one of the two heads, whereas the low-viscosity fluid may be ejected from the other head.

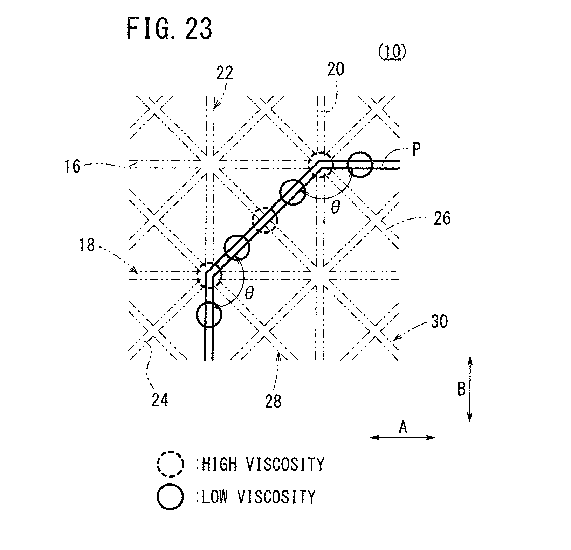

On the conductive pattern-forming substrate 10 shown in FIG. 6 having a temperature of 25° C, a first fluid (having a viscosity of 50 mPa·s at 25° C and a viscosity of 15 mPa·s at 80° C, controlled, for example, by changing the solid content concentration or by adding a viscosity modifier) was dropped from a first head having a temperature of 70° C onto the intersections, and a second fluid (having a viscosity of 15 mPa·s at 25°C) was dropped from a second head having a temperature of 25° C onto portions other than the intersections. The results are shown in FIG. 23 together with the initial positions of the fluid droplets. The initial positions of the droplets of the high-viscosity fluid are represented by broken lines, and the initial positions of the droplets of the low-viscosity fluid are represented by solid lines.

The first fluid was prepared by appropriately adding a mixture of glycerin and diethylene glycol (volume ratio 2:1) as a viscosity modifier to the second fluid. The first and second fluids were appropriately ejected from the first and second heads while controlling a driving voltage waveform of a piezo element.

As shown in FIG. 23, in this case, the fluid was prevented from flowing in a wrong direction at the intersections, so that a desired conductive pattern P was obtained.

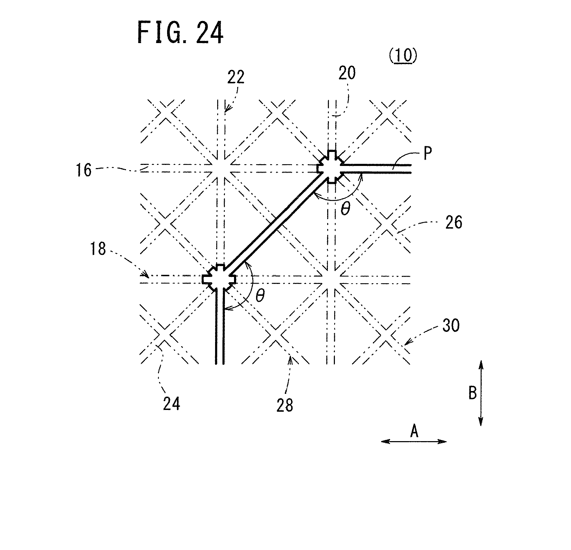

For comparison, a conductive pattern P was formed in the same manner as described above, except that only the second head was used and only the second fluid was dropped onto all of the portions. The results are shown in FIG. 24. In this case, the applied second fluid became blurred, so that a protrusion was formed having a width of approximately 1/5 to 1/3 of the grid width.

In the case that a slight protrusion is observed, as shown in FIG. 24, although there is no critical problem with such a protrusion, the possibility of failures such as short circuiting can be reduced by reducing the size of the protrusion. Thus, on the condition that the fluid, which has a high viscosity and is not readily moved, is made to land on the intersections, the quality of the resultant circuit board can be improved.

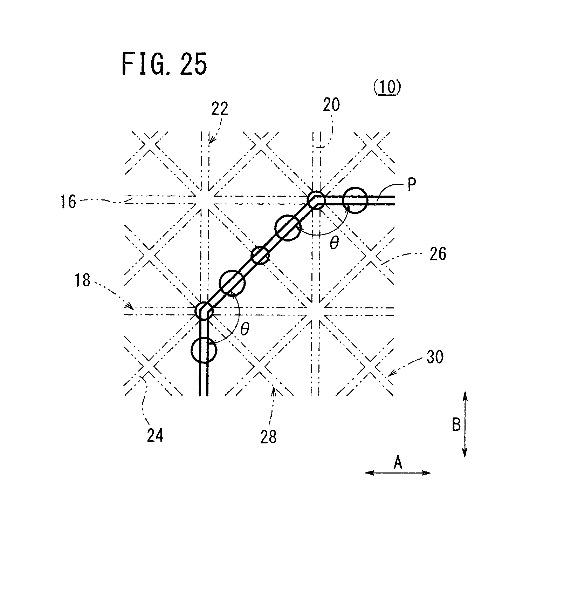

In view of preventing fluid from flowing in a wrong direction at the intersection, as shown in FIG. 25, the diameters of the fluid droplets that land on the intersections may be smaller than the diameters of the fluid droplets that land on other portions apart from the intersections. In this case, the amount of the landed fluid droplets is smaller at each intersection. Therefore, even on the condition that the fluid moves in a wrong direction on the holding region 14, only an extremely small protrusion is formed.

The term "diameter of the fluid droplet" implies an equivalent spherical diameter of the landed droplet. For example, in inkjet printing, practically, the diameter of the droplet can be controlled by changing the voltage waveform used for controlling ejection of ink from a piezo drive nozzle. The diameter of the fluid (ink) droplet on portions other than the intersection preferably is 1.5 to 10 times, more preferably, is 2 to 8 times, and particularly preferably, is 3 to 5 times, larger than the diameter of the fluid (ink) droplet at the intersection.

Alternatively, the fluid may be printed in the vicinity of the intersections, and thereafter, the fluid may be printed on other portions, in order to utilize the uniting properties due to surface tension of the droplets. In this case, flowing of the fluid in the wrong direction can effectively be prevented.

The present invention is not particularly limited to the embodiments described above. Various changes and modifications may be made to the embodiments without departing from the scope of the invention.

For example, although the size in the width direction of the central line of the three straight lines 16, 20 in the assembly 50, 52 is larger than the size of the other two lines shown in the example of FIG. 19, the three lines may have the same size in the width direction. Furthermore, the number of the straight lines 16, 20 in the assembly 50, 52 is not limited to three, and may be four, five, or more.

Although, in the examples of FIGS. 2, 7 to 11, and 14 to 18, the first straight lines 16 in the first straight line group 18 and the second straight lines 20 in the second straight line group 22 have the same size in the width direction, the first straight lines 16, 16 in the first straight line group 18 may have different sizes in the width direction, and the second straight lines 20, 20 in the second straight line group 22 may have different sizes in the width direction. Furthermore, the first straight lines 16 and the second straight lines 20 may have different sizes in the width direction, respectively.

The method for printing the fluid that forms the conductive pattern is not particularly limited to an inkjet printing method. Alternatively, the method may be a wax-jet printing method, an aerosol-jet printing method, a laser-jet printing method, etc.

The holding region may have a lattice pattern that contains a plurality of connected rhombus shapes.

Furthermore, the holding region 14 (36) may be formed on both surfaces of the conductive pattern-forming substrate 10, 62. In this case, a circuit board having a conductive pattern on either side thereof can be produced.

In addition, a material, the surface energy of which can be changed by irradiation of radiation, may be applied to at least one surface of the support 12. Upon irradiating the applied material with radiation, the surface energy difference between the irradiated portion and the non-irradiated portion can be increased. Thus, in this case, regions having different surface energies can be formed as a result of being irradiated with radiation. The region that exhibits higher wettability with respect to the fluid acts as the holding region 14.

### (Example 1)

A soluble polyimide, as described in paragraph [0109] of Japanese Laid-Open Patent Publication No. 2010-241113, was synthesized by the method described in Japanese Laid-Open Patent Publication No. 2009-013342.

Thereafter, the soluble polyimide was applied and patterned as described in paragraphs [0117] and [0118] of Japanese Laid-Open Patent Publication No. 2010-241113. During this step, an exposure process was carried out using a chrome mask available from Mitani Micronics Co., Ltd. and a metal halide lamp at 20 J/cm². The pattern had a line width W of 40 ± 2 µm and a distance D of 80 µm. By performing a static contact angle measurement on a uniform surface, it is known that the non-exposed portion exhibits a contact angle of 57°, and the exposed portion exhibits a contact angle of 26° with respect to the ink. Thus, it was confirmed that the exposed portion corresponds to a holding region.

A polar ink, FLOWMETAL SW-1020 (a silver nanoink available from Bando Chemical Industries, Ltd.), was dropped onto the patterned soluble polyimide in order to form the shape shown in FIG. 6. The applied ink was dried and sintered in order to obtain a conductive pattern. A 5 V direct-current power supply and a red LED were connected in series to ends of the conductive pattern, and light was emitted from the red LED. Thus, it was confirmed that the conductive pattern could be used as a circuit wiring.

As made clear from the above results, a plurality of regions, which have different surface energies (the non-exposed portion and the exposed portion), can be formed by applying the material having a variable surface energy property under application of radiation, and by irradiating the applied material with radiation. In other words, in this manner, the holding region can be formed, which has a fluid wettability higher than the fluid wettability of the surrounding regions.

## Claims

1. A conductive pattern-forming substrate (10), on which a conductive pattern is formed to produce a circuit board, comprising:
a support (12); and
a holding region (14) formed on at least one surface of the support (12) for holding a fluid (40) that forms the conductive pattern;
wherein:
the holding region (14) has a wettability with respect to the fluid (40) that is higher than that of a surrounding region around the holding region (14);
the holding region (14) contains at least a first straight line group (18) and a second straight line group (22), the first straight line group (18) contains a plurality of first straight lines (16) extending parallel to each other in a first direction, and the second straight line group (22) contains a plurality of second straight lines (20) extending parallel to each other in a second direction; and
the first straight line group (18) and the second straight line group (22) are combined to form lattice shapes.

2. The conductive pattern-forming substrate (10) according to claim 1, wherein the holding region (14) further contains a third straight line group (28), and the third straight line group (28) contains a plurality of third straight lines (24) extending parallel to each other from the first straight lines (16) toward the second straight lines (20) as diagonal lines of the lattice shapes.

3. The conductive pattern-forming substrate (10) according to claim 2, wherein the holding region (14) further contains a fourth straight line group (30), and the fourth straight line group (30) contains a plurality of fourth straight lines (26) extending parallel to each other as diagonal lines of the lattice shapes which differ from the third straight lines (24).

4. The conductive pattern-forming substrate (10) according to any one of claims 1 to 3, wherein the widths of the straight lines extending parallel to each other in the holding region (14) are smaller than the distances between the straight lines.

5. The conductive pattern-forming substrate (10) according to claim 1, wherein the holding region (14) has a surface energy, which is higher by at least 5 mJ/m² than a surface energy of the surrounding region around the holding region (14), and the holding region (14) is used for holding a polar fluid (40).

6. The conductive pattern-forming substrate (10) according to claim 1, wherein the holding region (14) has a surface energy, which is lower by at least 5 mJ/m² than a surface energy of the surrounding region around the holding region (14), and the holding region (14) is used for holding a non-polar fluid (40).

7. The conductive pattern-forming substrate (10) according to claim 1, wherein:
the first straight line group (18) and the second straight line group (22) contain a first broken line (32) and a second broken line (34), respectively, the first broken line (32) contains a plurality of the first straight lines (16) arranged on one axial line thereof, and the second broken line (34) contains a plurality of the second straight lines (20) arranged on one axial line thereof; and
a gap between the first straight lines (16) in the first broken line (32) corresponds to a gap between the second straight lines (20) in the second broken line (34).

8. The conductive pattern-forming substrate (10) according to claim 2, wherein:
the first straight line group (18), the second straight line group (22), and the third straight line group (28) contain a first broken line (32), a second broken line (34), and a third broken line (37), respectively, the first broken line (32) contains a plurality of the first straight lines (16) arranged on one axial line thereof, the second broken line (34) contains a plurality of the second straight lines (20) arranged on one axial line thereof, and the third broken line (37) contains a plurality of the third straight lines (24) arranged on one axial line thereof; and
a gap between the first straight lines (16) in the first broken line (32) corresponds to a gap between the second straight lines (20) in the second broken line (34) and a gap between the third straight lines (24) in the third broken line (37).

9. The conductive pattern-forming substrate (10) according to claim 3, wherein:
the first straight line group (18), the second straight line group (22), the third straight line group (28), and the fourth straight line group (30) contain a first broken line (32), a second broken line (34), a third broken line (37), and a fourth broken line (38), respectively, the first broken line (32) contains a plurality of the first straight lines (16) arranged on one axial line thereof, the second broken line (34) contains a plurality of the second straight lines (20) arranged on one axial line thereof, the third broken line (37) contains a plurality of the third straight lines (24) arranged on one axial line thereof, and the fourth broken line (38) contains a plurality of the fourth straight lines (26) arranged on one axial line thereof; and
a gap between the first straight lines (16) in the first broken line (32) corresponds to a gap between the second straight lines (20) in the second broken line (34), a gap between the third straight lines (24) in the third broken line (37), and a gap between the fourth straight lines (26) in the fourth broken line (38).

10. The conductive pattern-forming substrate (10) according to claim 1, wherein the support (12) contains a stack made up of at least one insulating layer and at least one conductive layer.

11. The conductive pattern-forming substrate (10) according to claim 1, wherein the holding region (14), which contains a plurality of the straight line groups, further contains a polymer having a hydrophilic group.

12. The conductive pattern-forming substrate (10) according to claim 1, wherein the region, which contains a plurality of the straight line groups and has a different surface energy, is formed by applying a material having a surface energy property that is variable by irradiation of radiation, and by irradiating the applied material with the radiation.

13. A method for producing a conductive pattern-forming substrate (10), on which a conductive pattern is formed to produce a circuit board, comprising a step of forming a holding region (14) on a support (12),
wherein:
the holding region (14) has a wettability with respect to a fluid (40) used for forming the conductive pattern that is higher than that of a surrounding region, and the holding region (14) is used for holding the fluid (40);
at least a first straight line group (18) and a second straight line group (22) are formed to thereby obtain the holding region (14), the first straight line group (18) contains a plurality of first straight lines (16) extending parallel to each other in a first direction, and the second straight line group (22) contains a plurality of second straight lines (20) extending parallel to each other in a second direction; and
the first straight line group (18) and the second straight line group (22) are combined to form lattice shapes.

14. The method according to claim 13, wherein, the forming step of the holding region (14) comprises a step of printing a holding region-forming fluid (40) for forming the holding region (14).

15. The method according to claim 13, wherein a third straight line group (28) is further formed to thereby obtain the holding region (14), and the third straight line group (28) contains a plurality of third straight lines (24) extending from the first straight lines (16) toward the second straight lines (20) as diagonal lines of the lattice shapes.

16. The method according to claim 15, wherein a fourth straight line group (30) is further formed to thereby obtain the holding region (14), and the fourth straight line group (30) contains a plurality of fourth straight lines (26) extending as diagonal lines, which differ from the third straight lines (24).

17. The method according to claim 13, wherein a first broken line (32) and a second broken line (34) are formed in the first straight line group (18) and the second straight line group (22), respectively, the first broken line (32) contains a plurality of the first straight lines (16) arranged on one axial line thereof, and the second broken line (34) contains a plurality of the second straight lines (20) arranged on one axial line thereof; and
a gap between the first straight lines (16) in the first broken line (32) corresponds to a gap between the second straight lines (20) in the second broken line (34).

18. The method according to claim 15, wherein a first broken line (32), a second broken line (34), and a third broken line (37) are formed in the first straight line group (18), the second straight line group (22), and the third straight line group (28), respectively, the first broken line (32) contains a plurality of the first straight lines (16) arranged on one axial line thereof, the second broken line (34) contains a plurality of the second straight lines (20) arranged on one axial line thereof, and the third broken line (37) contains a plurality of the third straight lines (24) arranged on one axial line thereof; and
a gap between the first straight lines (16) in the first broken line (32) corresponds to a gap between the second straight lines (20) in the second broken line (34) and a gap between the third straight lines (24) in the third broken line (37).

19. The method according to claim 16, wherein a first broken line (32), a second broken line (34), a third broken line (37), and a fourth broken line (38) are formed in the first straight line group (18), the second straight line group (22), the third straight line group (28), and the fourth straight line group (30), respectively, the first broken line (32) contains a plurality of the first straight lines (16) arranged on one axial line thereof, the second broken line (34) contains a plurality of the second straight lines (20) arranged on one axial line thereof, the third broken line (37) contains a plurality of the third straight lines (24) arranged on one axial line thereof, and the fourth broken line (38) contains a plurality of the fourth straight lines (26) arranged on one axial line thereof; and
a gap between the first straight lines (16) in the first broken line (32) corresponds to a gap between the second straight lines (20) in the second broken line (34), a gap between the third straight lines (24) in the third broken line (37), and a gap between the fourth straight lines (26) in the fourth broken line (38).

20. The method according to any one of claims 17 to 19, wherein an additional holding region (14) for holding the fluid (40) is formed in the gap.

21. A circuit board comprising the conductive pattern-forming substrate (10) according to any one of claims 1 to 12, and a conductive pattern, wherein the conductive pattern is formed on a portion in the holding region (14) that contains a plurality of the straight line groups.

22. A method for producing a circuit board comprising the step of forming a conductive pattern on the conductive pattern-forming substrate (10) according to any one of claims 1 to 12, wherein the conductive pattern is formed on a portion in the holding region (14) that contains a plurality of the straight line groups.

23. The method according to claim 22, further comprising the steps of:
non-contact-printing the fluid (40) on the holding region (14); and
forming the conductive pattern from the fluid (40).

24. The method according to claim 23, further comprising the step of subjecting the conductive pattern to a plating treatment in order to form a conductive layer thereon.

25. The method according to claim 22, further comprising the steps of:
forming two or more regions having different surface energies on the support (12) in order to prepare the conductive pattern-forming substrate (10), the support (12) containing a stack made up of at least one insulating material layer and at least one conductive metal layer;
non-contact-printing the fluid (40) on a portion in the regions;
forming an etching resist mask from the fluid (40);
performing an etching treatment in order to remove the holding region (14) and the conductive metal layer from a portion that is not covered with the etching resist mask; and
removing the etching resist mask, thereby exposing the conductive metal layer that forms the conductive pattern.

26. The method according to claim 23, wherein the step of non-contact printing comprises an inkjet printing process.

27. The method according to claim 26, further comprising the steps of dropping a first ink onto at least an intersection of the first straight line (16) and the second straight line (20), and dropping a second ink onto a portion other than the intersection, wherein the viscosity of the second ink is lower than that of the first ink.

28. The method according to claim 26, wherein a dot diameter of a droplet on at least an intersection of the first straight line (16) and the second straight line (20) is larger than dot diameters on portions other than the intersection.
